# EUROPEAN PATENT APPLICATION

(11) **EP 1 596 426 A1**
(43) Date of publication of application: **16.11.2005**
(21) Application number: 04712220.5
(22) Date of filing: 18.02.2004
(51) Int. Cl.: H01L 21/205, H01L 21/31, C23C 16/448

(54) **CARBURETOR, METHOD OF VAPORIZING MATERIAL SOLUTION, AND METHOD OF WASHING CARBURETOR**

(30) Priority: 18.02.2003 JP 2003040421
(71) Applicant: Wacom Electric Co. Ltd., Tokyo 103-0022 (JP)
(72) Inventor: YAMOTO, Hisayoshi, c/o WACOM ELECTRIC CO., LTD., Tokyo 103-0022 (JP); SAKAI, Ryoichi, c/o WACOM ELECTRIC CO., LTD., Tokyo 103-0022 (JP); SHOJI, Masafumi, c/o WACOM ELECTRIC CO., LTD., Tokyo 103-0022 (JP); AKUTO, Kazuya, c/o WACOM ELECTRIC CO., LTD., Tokyo 103-0022 (JP); NAGAOKA, Ken, c/o WACOM ELECTRIC CO., LTD., Tokyo 103-0022 (JP); WATANUKI, Hiroshi, c/o WACOM ELECTRIC CO., LTD., Tokyo 103-0022 (JP)
(74) Representative: Dr. Weitzel & Partner
(86) International application number: PCT/JP2004/001807
(87) International publication number: WO 2004/075271

(57) **Abstract**

There is obtained an MOCVD oriented vaporizer which eliminates a phenomenon that thin-film materials are adhered to a portion of the vaporizer near and around a spout thereof. A carrier gas/small amount oxidizing gas supply part 11 supplies a carrier gas, which is supplied through an internally formed gas passage and which contains a material solution, to a vaporization part; a bubble prevention/material solution supply part 12 supplies a material for preventing generation of bubbles of the carrier gas containing the material solution, and the material solution, into the carrier gas; a solvent vaporization restricting/cooling system 13 restricts vaporization of a solvent; and a swirl flow preventing gas supply part 14 supplies a gas for preventing occurrence of swirl flows near a gas outlet of the vaporization part. An atomizing part 15 causes the carrier gas, which contains the material solution and which is ejected from the vaporizer 20, to be formed into a finely atomized state; and a complete vaporization oriented high performance vaporization tube 16 completely vaporizes the carrier gas ejected from the vaporizer 20 and containing the material solution. This enables long-term usage without clogging and the like, and enables a stable material supply to a reaction part.

## Description

### TECHNICAL FIELD

The present invention is utilizable in a vaporizer and a material solution vaporizing method for wafer production such as in development of DRAM, and more particularly, relates to a vaporizer and a material solution vaporizing method for MOCVD (metalorganic chemical vapor deposition).

### BACKGROUND ART

Concerning vaporizers and vaporizing methods for an MOCVD oriented material solution, to which the present invention relates, SrBi₂TaO₉ ferroelectric thin-film formation is generally achieved by a practical and promising MOCVD (metalorganic chemical vapor deposition) method.

Problematic in development of DRAM as one kind of memory, is a storage capacitance accompanying to scale-down for such a memory. Because capacitances are required to be at the same level as the former generation from a standpoint of soft error and the like, some countermeasures are necessary. As one countermeasure, it has been contemplated to increase each capacitor area by adopting a three-dimensional structure which is exemplarily called stack structure/trench structure for cell structures of 4M or more, though planar structures have been used in cell structures of 1M or less. Also, adopted as dielectric films are stacked films (which are typically called ON films) obtained by stacking thermal oxidation films and CVD nitride films on poly-Si, instead of thermal oxidation films on substrate Si. In 16M DRAM's, there have been adopted a thick film type utilizing side surfaces, a fin type utilizing reverse surfaces of a plate, or the like, in the stack type, so as to increase a surface area contributing to each capacitance.

However, regarded as problems in such three-dimensional structures are an increased number of procedures due to a complicated process and a deteriorated yield due to increased step height differences, thereby leading to an assumption that more than 256M bits will be hardly realized. As such, there has been thought out an approach to replace a dielectric of a capacitance by a ferroelectric having a higher dielectric constant, as one solution for further increasing a degree of integration without changing a DRAM structure at the present time. Then, attention has been firstly directed to thin-films of oxides of paraelectric monometal having a higher dielectric constant such as Ta₂O₅, Y₂O₃, HfO₂, and the like, as dielectric thin-films having higher dielectric constants. Note that respective specific dielectric constants are 28 for Ta₂O₅, 16 for Y₂O₃, and about 24 for HfO₂, which are 4 to 7 times that of SiO₂.

There is still required, however, a three-dimensional capacitor structure for application of DRAM of more than 256M. There are accordingly so expected three kinds of materials for application to DRAM's, i.e., (BaₓSr₁₋ₓ)TiO₃, Pb(Zr_{y}Ti_{1-y})O₃, and (PbₐL₁₋ₐ)(Zr_{b}Ti_{1-b})O₃, which have specific dielectric constants higher than the above oxides, respectively. Also promising are Bi-based laminar ferroelectric materials having crystal structures similar to those of superconductive materials, and attention has been recently and strongly directed to SrBi₂TaO₉ called Yl material in that it is driven at a lower voltage and has excellent fatigue characteristics.

Generally, SrBi₂TaO₉ ferroelectric thin-film formation is achieved by a practical and promising MOCVD (metalorganic chemical vapor deposition) method.

In such a vaporizer and a vaporizing method for an MOCVD oriented material solution, examples of starting materials of ferroelectric thin-films include organometallic complexes Sr(DPM)₂, Bi(C₆H₅)₃, and Ta(OC₂H₅)₅, which are each used as a solution by dissolving them in THF (tetrahydrofuran) solvent, respectively. Note that DPM is an abbreviation of dipivaloyl methane.

Apparatuses used for an MOCVD method are each configured with: a reaction part configured to cause gas phase reaction and surface reaction of SrBi₂TaO₉ thin-film oriented materials to thereby achieve film formation thereof; a supply part configured to supply the SrBi₂TaO₉ thin-film oriented materials and an oxidizing agent to the reaction part; and a collection part configured to collect products in the reaction part. Further, the supply part is provided with a vaporizer configured to vaporize the thin-film materials.

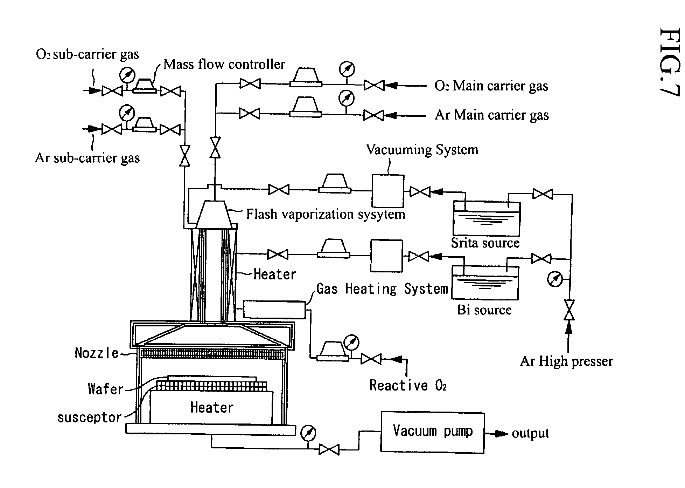

FIG. 7 is a conceptional view of an exemplary system constitution for a conventional MOCVD oriented vaporizer. FIG. 7 shows a known technique example concerning a conventional vaporizer, and illustrates an outline of an exemplary constitution of a typical MOCVD apparatus. In FIG. 7, placed on a heater at the bottom of the figure, is a wafer as a target for surface treatment, through a susceptor. Constituted at the above is a treatment gas supply part for the wafer.

Supplied from the treatment gas supply part are gases (main carrier gas/sub-carrier gas) such as O₂, Ar, and vaporized in a flash vaporization system are organometallic complexes Sr(DPM)₂, Bi(C₆H₅)₃, and Ta(OC₂H₅)₅ as starting materials of ferroelectric thin-films. The thus vaporizedly obtained gases are passed through a heater part and a nozzle, to thereby carry out a surface treatment of the wafer placed on the susceptor.

However, in the conventional technique, there is caused such a phenomenon that the thin-film materials are adhered to a portion of the vaporizer near and around a spout thereof, the vaporizer being acting as the supply part. The adhered matters, which are solidified thin-film materials, grow with the lapse of time. The solidified thin-film materials cause various troubles including occlusion of a gas inlet (spout of the vaporizer), thereby causing a problem against a long-term usage of the MOCVD oriented vaporizer.

To remove such obstacles, there has been conventionally achieved disassembling to thereby dismount various parts, and to duly wash or replace them. This work requires a long period of time, thereby decreasing an operation efficiency of the vaporizer and deteriorating a deposition process in the MOCVD.

Further, to obtain a film excellent in uniformity in the MOCVD, it is required to provide a vaporizedly obtained gas containing uniformly dispersed components of material solutions. However, the above-mentioned related art is not necessarily capable of meeting such a requirement.

It is therefore an object of the present invention to provide a vaporizer capable of eliminating such a phenomenon that thin-film materials are adhered to a portion of the vaporizer near and around a spout thereof, enabling a long-term usage, and enabling a stable material supply to a reaction part.

It is another object of the present invention to provide a material solution vaporizing method capable of providing a vaporizedly obtained gas containing uniformly dispersed components of material solutions.

### DISCLOSURE OF THE INVENTION

The present invention resides in a vaporizer configured to introduce a film-forming material supplied via gas passage, into a vaporization part from an inlet, to thereby vaporize the material solution in the vaporization part, characterized in that the vaporizer is provided with washing means for ejecting a wash liquid toward the inlet.

Further, the vaporizer is an MOCVD (metalorganic chemical vapor deposition) oriented vaporizer; the wash liquid contains a solvent for an organic metal contained in the material solution; a plurality of washer solvent supply lines are provided to enclose an outer periphery of a gas ejecting end portion of the vaporization part; and the plurality of washer solvent supply lines are set to have predetermined angles relative to a center of the gas ejecting end portion of the vaporization part so that wash liquid streams to be ejected from the plurality of washer solvent supply lines are allowed to be ejected in a swirl state relative to the gas ejecting end portion of the vaporizer.

It is preferable that the predetermined angles are each within a range of 1 degree to 15 degrees relative to the center line of the gas ejecting end portion, and that the vaporizer further comprises an air cooling pipe provided near and around the plurality of washer solvent supply lines so that the washer solvent is cooled to thereby prevent a solvent from being vaporized before washing.

Note that it is desirable that the washer solvent supply line is configured to be arranged at a position just below the gas ejecting end portion; that the end portion of the washer solvent supply line is configured as a washer nozzle; and that the wash liquid stream containing a solvent is ejected from the end of the washer nozzle, to achieve more effective removal of adhered and hardened matters comprising a thin-film material adhered to an outer periphery of the gas ejecting end portion of the vaporization part.

Recited in the invention of Claim 11 is a vaporizer having a vaporization part configured to vaporize a carrier gas which is supplied through an internally formed gas passage and which contains a material solution, characterized in that the vaporizer is configured to include: a first supply part configured to supply the carrier gas to the vaporization part; a second supply part configured to supply the material solution into the carrier gas; and a third supply part configured to supply a gas acting on the carrier gas emitted from a gas outlet of the vaporization part, near the gas outlet.

It is preferable that the action is an aiding action for preventing occurrence of swirl flows near the gas outlet of the vaporization part for the carrier gas; that the swirl flow occurrence prevention means comprises gas jets in a downward direction near the gas outlet; and that the gas jets for the swirl flow occurrence prevention means are ultra high-speed gas streams.

It is also preferable that the vaporizer is one for MOCVD (metalorganic chemical vapor deposition); that the vaporizer further comprises a cooling system part configured to restrict vaporization of the material solution; and that the vaporizer further comprises a complete vaporization oriented high performance vaporization tube configured to define a high performance operation area to thereby completely vaporize the carrier gas which is to be ejected from the vaporization part and which contains the material solution.

The present invention also provides a material solution vaporizing method of vaporizing, by a vaporizer, a carrier gas which is supplied through an internally formed gas passage and which contains a material solution, characterized in that the method comprises: a vaporization part gas supply step for supplying a gas to the vaporization part; a carrier gas supply step for supplying: a material for preventing generation of bubbles of the carrier gas containing the material solution; and the material solution; into the carrier gas; a cooling step for restricting vaporization of a solvent by cooling; and a swirl flow prevention gas supply step for supplying a gas for preventing occurrence of swirl flows near a gas outlet of the vaporization part.

Note that it is desirable that the gas supply in the swirl flow prevention gas supply step comprises ultra high-speed gas streams in the downward direction near the gas outlet of the vaporization part, for the purpose of forming the carrier gas, which is ejected from the vaporizer and which contains the material solution, into a finely atomized state; and that the method further comprise the step of: decreasing an amount of an O gas to be supplied from the below, and achieving a vacuuming treatment by adding an O gas to an N₂ gas, for the purpose of enhancing implementability of formation of the finely atomized state.

The present invention further provides a vaporizer washing method for a vaporizer configured to introduce a film-forming solution supplied via gas passage, into a vaporization part from an inlet, to thereby vaporize the material solution in the vaporization part, characterized in that the method comprises the step of: ejecting a wash liquid toward the inlet.

Characterizedly, the film-forming material, the wash liquid, is dissolved in a solvent. Further, film-forming material for MOCVD is introduced into the vaporization part in a gas/liquid mixed state (gas/liquid mixed gas state) by containing the film-forming material in an atomized state into a carrier gas such as Ar. Additionally, it is possible to include an oxygen gas, e.g., into the gas/liquid mixed gas, depending on a film-formation condition.

Characterizedly, the wash liquid is a solvent in which the film-forming material is soluble. Used as the solvent is toluene, ECH or the like, for example. It is further possible to mix a plurality of kinds of solvents with each other, in consideration of vapor pressures, solubilities, and the like thereof.

Characterizedly, the washing is achieved by bringing the vaporization part into a reduced pressure state. Although it is possible that the vaporization part is opened to the atmosphere upon washing, it is desirable that washing is achieved in the reduced pressure state because a certain period of time is required to bring it back to the reduced pressure state again.

Characterizedly, the wash liquid is ejected at a rate of 30cc/min or more. Supplying the wash liquid at a rate of 30cc/min or more causes the wash liquid to be constantly kept in a liquid phase. Namely, the vaporization part is usually kept at a high temperature, and in a reduced pressure state. Supplying a wash liquid to such a state leads to vaporization of the wash liquid, thereby possibly losing a washing effect. Nonetheless, the present inventors have found that supplying a wash liquid at a rate of 30cc/min or more fully removes matters deposited or adhered to the inlet or therearound, in an extremely short time (10 seconds or shorter). Conversely, it was found that rates less than 30cc/min lead to an excessive time for removing deposited matters or adhered matters, and leave residues. Although the reason thereof is not clear, it is considered that supplying at a rate of 30cc/min or more causes a wash liquid to contact with deposited matters or adhered matters constantly in a liquid phase state of the wash liquid. Rates of 50cc/min or more are preferable. However, rates exceeding 100cc/min lead to a saturated effect, so that a rate of 100cc/min is preferable as an upper limit.

Characterizedly, the inlet and the jet port of the wash liquid are set at 25 mm or less in distance therebetween. Distances of 40mm or less lead to remarkable washing effects. Fifteen mm or less is more preferable.

Characterizedly, the vaporization part is provided with a drain port, the drain port is provided with a gas ejector, and an exclusion/disposal device is connected to a downstream of the gas ejector.

The wash liquid after achievement of washing is accumulated at a lower portion of the vaporization part, unless the wash liquid is drained from the vaporizer. Usually, the downstream of the vaporizer is connected to a film-formation apparatus, so that the wash liquid after washing intrudes into the film-formation apparatus. Thus, the drain port is provided at the lower portion of the vaporization part, thereby draining the wash liquid after washing to the outside of the vaporization part.

At that time, the ejector pipe is provided at the drain port, for passing a gas therethrough. Further, the ejector pipe is set to allow a gas such as air to be introduced into the ejector pipe through one end thereof. The other end of the ejector pipe is connected to the exclusion/disposal device. Flowing a gas from one end brings a connection part between the drain port and the ejector pipe into a reduced pressure state, so that the wash liquid after washing is drained from the drain port into the ejector pipe. The wash liquid after washing carried out into the ejector pipe is drawn into a gas flow and introduced into the exclusion/disposal device. In this way, the wash liquid after washing can be drained without causing a reduced pressure state of the vaporization part. As a result, washing can be achieved without causing a reduced pressure state. It is of course possible to achieve washing, by bringing the vaporization part into the atmosphere state.

### BRIEF DESCRIPTION OF THE DRAWINGS

FIG. 1 is a cross-sectional view of essential parts of a constitution of an MOCVD oriented vaporizer according to an embodiment 1.

FIG. 2 is a conceptional view for explaining a principle of operation for restricting occurrence of a phenomenon of thin-film material adhesion.

FIG. 3 shows a configuration of an adhered matter removal apparatus configured to effectively remove thin-film materials adhered to a portion of a vaporizer according to an embodiment 2 near and around a spout of the vaporizer.

FIG. 4 is a conceptional view for explaining an exemplary constitution of three washer solvent supply lines of FIG. 3.

FIG. 5 is a cross-sectional view of essential parts of a configuration of a washing apparatus for an MOCVD oriented vaporizer according to an embodiment 3.

FIG. 6 is a view of a configuration of a vaporization pipe utilizable in the embodiment 2 and embodiment 3.

FIG. 7 is a conceptional view of an exemplary system constitution of a conventional MOCVD oriented vaporizer.

### (Explanation of reference numeral)

- 11: carrier gas/small amount oxidizing gas supply part
- 12: bubble prevention/material solution supply part
- 13: solvent vaporization restricting/cooling system
- 14: swirl flow preventing gas supply part
- 15: atomizing part
- 16: complete vaporization oriented high performance vaporization tube
- 20, 30: vaporizer
- 31: washer solvent supply line
- 32: air cooling pipe
- 41: gas ejection small port (sample carrier nozzle)
- 42: washer nozzle
- 43: air
- 44: vacuuming
- 45: exhaust trap
- 46: solvent tank

### BEST MODE FOR CARRYING OUT THE INVENTION

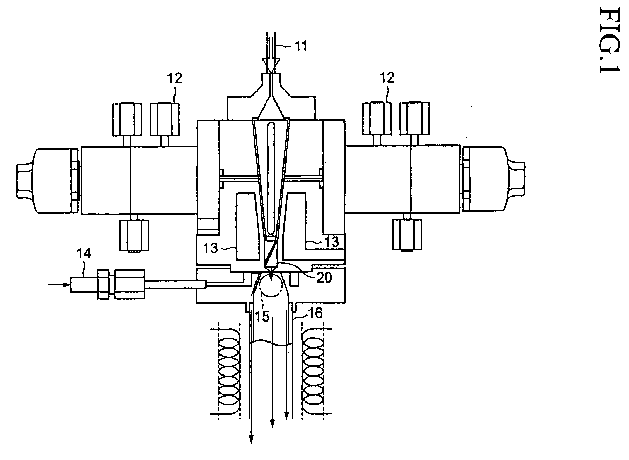

There will be detailedly explained embodiments of a vaporizer and a material solution vaporizing method according to the present invention with reference to the accompanying drawings. Referring to FIG. 1 through FIG. 6, there are shown respective configurations of a vaporizer and a material solution vaporizing method of the present invention. Note that embodiments 1 through 3 to be described hereinafter correspond to partial improvements of a constitutional apparatus at a vaporization passage part so as to eliminate such a phenomenon that thin-film materials are adhered to a portion of a vaporizer near and around a spout thereof, which has been a problem in the conventional example.

### (Embodiment 1)

FIG. 1 shows essential parts of a constitution of an MOCVD oriented vaporizer according to an embodiment 1. In FIG. 1, the MOCVD oriented vaporizer of the embodiment 1 is configured to include a carrier gas/small amount oxidizing gas supply part 11, a bubble prevention/material solution supply part 12, a solvent vaporization restricting/cooling system 13, a swirl flow preventing gas supply part 14, an atomizing part 15, and a complete vaporization oriented high performance vaporization tube 16.

Note that the complete vaporization oriented high performance vaporization tube 16 is provided to define a high performance operation area for a carrier gas to thereby completely vaporize the carrier gas which is to be ejected from a vaporization part and which contains material solutions. Utilizable as the complete vaporization oriented high performance vaporization tube 16 is a vaporization pipe shown as an embodiment 4 to be described hereinafter, and gas is supplied via nozzle to a wafer on a susceptor.

The carrier gas/small amount oxidizing gas supply part 11 is a gas supply part configured to supply a carrier gas containing material solutions to be supplied through a gas passage formed within the gas supply part, to a vaporization part. The bubble prevention/material solution supply part 12 is a supply part configured to supply: a material for preventing generation of bubbles of the carrier gas containing the material solutions; and the material solutions; into the carrier gas. The solvent vaporization restricting/cooling system 13 is a cooling system part configured to restrict vaporization of a solvent.

The swirl flow preventing gas supply part 14 is a gas supply part configured to supply a gas for preventing occurrence of a swirl flow near a gas outlet of the vaporization part.

The atomizing part 15 is a state area where the carrier gas, which is ejected from a vaporizer 20 and which contains material solutions, is formed into a finely atomized state.

The complete vaporization oriented high performance vaporization tube 16 is a high performance operation area tube configured to completely vaporize the carrier gas ejected from the vaporizer 20 and containing material solutions.

The swirl flow preventing gas supply part 14 is established in the MOCVD oriented vaporizer according to the embodiment 1 having the above constitution, so as to generate a swirl flow to thereby restrict occurrence of a phenomenon that thin-film materials are adhered to a portion of the vaporizer near and around a spout thereof. By virtue of the swirl flow preventing gas supply part 14, there is newly formed the atomizing part 15 by ultra high-speed gas streams near and around the spout. Note that the atomizing part 15 newly formed by ultra high-speed gas streams is a conceptional vaporization flow part, which serves to eliminate such a phenomenon that thin-film materials are adhered to a portion of the vaporizer 20 acting as the supply part near and around the spout thereof, which has been a problem in the conventional.

As an exemplary countermeasure for enhancing implementability, the swirl flow preventing gas supply part 14 is increased in gas flow of swirl flow. To this end, there is exemplarily decreased an amount of oxygen gas (O₂ gas) to be supplied from the below for vacuuming. Instead, it is exemplarily achieved to add an O₂ gas to a carrier gas such as Ar gas or N₂ gas.

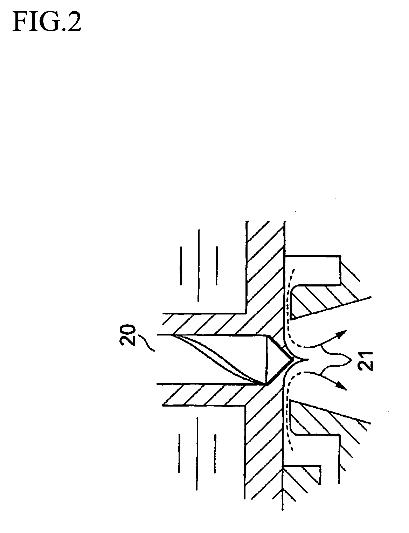

FIG. 2 is a conceptional view for explaining a principle of operation for restricting occurrence of the above-mentioned phenomenon of thin-film material adhesion. In FIG. 2, gases supplied from the swirl flow preventing gas supply part 14 form radial flows around the gas ejection small port of the vaporizer 20, thereby preventing occurrence of swirl flow. Further, in FIG. 2, arrows 21 shown at an end of the vaporizer 20 conceptually represent a formational configuration of radial gas flows. The gas ejection small port of the vaporizer 20 at a central portion thereof is protruded in a mountain-like shape, and the radial gas flows are formed by gases emitted from around the vaporizer 20. The thus formed radial flows prevent adhered matters, which are thin-film materials, from dwelling around the gas ejection small port, and effectively avoid occurrence of adhered matters around the gas ejection small port.

In the embodiment 1, clogging was caused at the spout after treatment of about 100 pieces of wafers, in a wafer treatment experiment where air cooling was achieved from the above relative to the position of the gas ejection small port accompanying to the implementation of the solvent vaporization restricting/cooling system 13. This data corresponds to a treatment process over three to four days, thereby prolonging a period of time for occurrence of clogging of the spout by several times longer than that for a treatment in the conventional technique.

### (Embodiment 2)

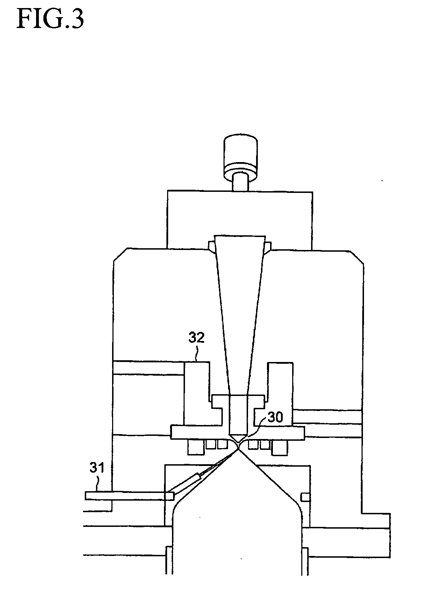

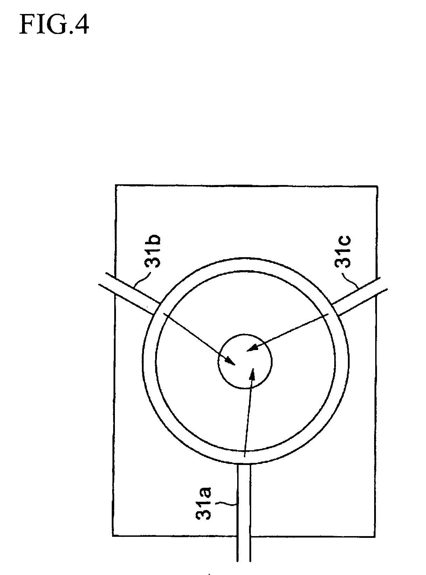

FIG. 3 and FIG. 4 show an embodiment of an adhered matter removal apparatus configured to effectively remove thin-film materials adhered to a portion of a vaporizer near and around a spout thereof. Note that FIG. 4 is a conceptional view for explaining an exemplary constitution of three washer solvent supply lines of FIG. 3.

This embodiment 2 is configured to effectively remove adhered thin-film materials, in case of occurrence of an adhesion phenomenon of thin-film materials to a portion of the vaporizer near and around the spout thereof. Further, combined usage of the embodiment 2 with the embodiment 1 enables a further improvement of an occurrence of spout clogging improved by the above described embodiment 1.

In FIG. 3 and FIG. 4 showing the embodiment 2, provided in an MOCVD oriented vaporizer corresponding to the embodiment 2, are three washer solvent supply lines 31a, 31b, 31c configured to supply washer solvent to an end portion of a gas ejection small port of the vaporizer 30. Further, provided near and around the three washer solvent supply lines 31a, 31b, 31c is an air cooling pipe 32.

The MOCVD oriented vaporizer having the above configuration according to the embodiment 2 is newly provided with the washer solvent supply lines 31 and the air cooling pipe 32 to cool a washer solvent, thereby preventing the solvent from evaporating into a gas before washing. This countermeasure achieves prevention of an adhesion phenomenon of thin-film materials which is susceptible to be caused around an end portion of the gas ejection small port of the vaporizer 30, and prevention of a solidification phenomenon of thin-film materials.

In the embodiment, washing is more effective when achieved at multi points from oblique directions, respectively. Exemplarily and more concretely, nozzles are provided by three in number to thereby improve efficiency of the function of the washer solvent to be ejected from the nozzles.

Further, there is exemplarily adopted an air ejector for feeding air to thereby supply the washer solvent. This allows washing, without bringing an interior of a chamber as a treatment target, back to the atmosphere level. However, washing is also possible by bringing it back to the atmosphere level.

Exemplarily supplied as a flow solvent example utilized as a washer solvent, are toluene for 10 seconds and ethylcyclohexane for 1.5 seconds. Further, it is suitable to feed a sufficient solvent for washing under a reduced pressure. For example, there is set a supply amount of 30cc/minute.

### (Embodiment 3)

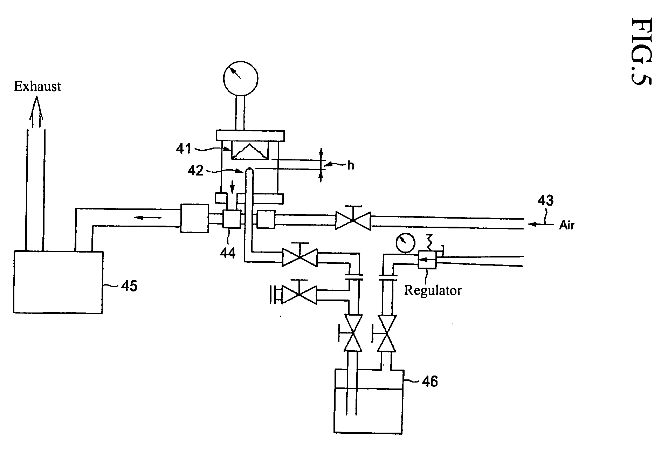

FIG. 5 shows a configuration of a washing apparatus, and an embodiment of an adhered matter removal apparatus configured to effectively remove thin-film materials adhered to a portion of a vaporizer near and around a spout thereof. This embodiment 3 has the same object as the embodiment 2, and is configured to effectively remove adhered thin-film materials, in case of occurrence of an adhesion phenomenon of thin-film materials to a portion of the vaporizer near and around the spout thereof. Note that this embodiment 3 is configured to further improve an occurrence of spout clogging improved by the above described embodiment 1.

In FIG. 5 showing the embodiment 3, the MOCVD oriented vaporizer corresponding to the embodiment 3 is provided with a washer nozzle 42 arranged just below an end portion of a gas ejection small port (sample carrier nozzle) 41 of the vaporizer, so as to supply a washer solvent to the end portion of the gas ejection small port. Shown in FIG. 5 illustrating the embodiment 3, is a spacing distance "h" between the end portion of the gas ejection small port 41 and an end portion of the washer nozzle 42.

The MOCVD oriented vaporizer according to the embodiment 3 having the above configuration is newly provided with the washer nozzle 42 so as to facilitate an operation for removing those adhered matters comprising thin-film materials which are susceptible to be caused around an end portion of the gas ejection small port of the vaporizer.

In the embodiment, ejected from the end of the washer nozzle 42 is a wash liquid including a solvent from a solvent tank 46, to thereby eject a washer solvent toward the end portion of the sample carrier nozzle 41. The thus ejected washer solvent more effectively removes adhered and hardened matters comprising thin-film materials adhered to the end portion to the sample carrier nozzle 41.

At the time of washing, it is required to lower a pressure within a chamber accommodating the sample carrier nozzle 41 therein, to thereby effectively eject the washer solvent from the washer nozzle 42. To this end, air 43 is fed by an air ejector to thereby carry out vacuuming 44, by virtue of a suction effect. The thus sucked matters are exhausted via exhaust trap 45.

As an experimental result in case of adopting toluene as a solvent, there was achieved removal of contamination for a period of time shorter than 5 seconds, while adopting exemplary constants in the washing, including the spacing distance "h"=15, a pressure of 0.1MPa within the solvent tank 46, a flow rate of 50cc/min, and a nozzle diameter of 0.3 φ of the sample carrier nozzle 41. Note that it is preferable for a solvent to be ejected from the sample carrier nozzle 41, to have a vapor pressure of 5 to 100 Torr, and optimally 10 to 50 Torr.

### (Embodiment 4)

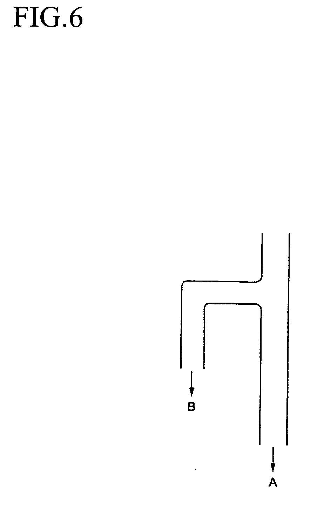

FIG. 6 is a view of a configuration of a vaporization pipe utilizable in the second embodiment and third embodiment. Shown in the embodiments 2 and 3 are exemplary constitutions of the adhered matter removal apparatus configured to effectively remove thin-film materials adhered to a portion of a vaporizer near and around a spout thereof. In practicing the embodiments 2 and 3, it is required to eliminate adhered and removed matters without bringing about troubles in a wafer as a treatment target. To this end, the vaporization pipe is provided with a passage B extended in a sideward direction, in addition to a passage A extended in a directly downward direction. There is supplied a treatment gas for a wafer, through the sideward passage B. This facilitates elimination of obstacles from within a wafer treatment chamber.

Note that the above described configurations are preferable examples for implementing the present invention. However, the present invention is not limited thereto, and many variants are practicable within the scope of the present invention without departing from the spirit thereof.

### INDUSTRIAL APPLICABILITY

As apparent from the above description, the vaporizer and the material solution vaporizing method of the present invention are configured to comprise: supplying a carrier gas to a vaporization part; supplying material solutions into the carrier gas; and possessing a washer solvent supply line configured to eject a wash liquid to an outer periphery of a gas ejecting end portion of the vaporization part. This configuration enables more effective removal of adhered and hardened matters comprising thin-film materials adhered to the gas ejecting end portion of the vaporization part.

Further, application of the vaporizer to MOCVD (metalorganic chemical vapor deposition) is made effective, thereby enabling an improved washing effect by including a solvent for organic metals in the wash liquid. Further, the washing effect can be more enhanced by providing a plurality of washer solvent supply lines around an outer periphery of the gas ejecting end portion of the vaporization part, by setting the washer solvent supply lines to have predetermined angles relative to a center of the gas ejecting end portion, and by ejecting the wash liquid streams from the plurality of washer solvent supply lines in a swirl state. Furthermore, the washing effect can be more enhanced by adjustment of the angles relative to the center line, cooling of the washer solvent, and the like.

Moreover, it becomes possible to restrict occurrence of adhesion of thin-film materials to the gas ejecting end portion of the vaporization part, by supplying a gas acting on the carrier gas emitted from the gas outlet of the vaporization part, near the gas outlet. The effect can be enhanced, by providing the action as an aiding action for preventing occurrence of swirl flows near the gas outlet of the vaporization part, and by providing the acting gas as ultra high-speed gas streams comprising gas jets in the downward direction near the gas outlet.

## Claims

1. A vaporizer configured to introduce a film-forming material supplied via gas passage, into a vaporization part from an inlet, to thereby vaporize the material solution in the vaporization part, **characterized in**
**that** said vaporizer is provided with washing means for ejecting a wash liquid toward said inlet.

2. The vaporizer of claim 1, **characterized in that** said vaporizer is an MOCVD (metalorganic chemical vapor deposition) oriented vaporizer

3. The vaporizer of claim 1 or 2, **characterized in that** the wash liquid is a solvent for dissolving the film-forming material therein.

4. The vaporizer of any one of claims 1 through 3, **characterized in that** said washing means is plurally provided to enclose an outer periphery of an end portion of said inlet.

5. The vaporizer of claim 4, **characterized in that** said plurality of washing means are set to have predetermined angles relative to a center of said inlet so that wash liquid streams to be ejected from said plurality of washing means are allowed to be ejected in a swirl state relative to said gas ejecting end portion of said vaporizer.

6. The vaporizer of claim 5, **characterized in that** said predetermined angles are each within a range of 1 degree to 15 degrees relative to the center line of said gas ejecting end portion.

7. The vaporizer of any one of claims 4 through 6, **characterized in that** said vaporizer further comprises an air cooling pipe provided near and around said plurality of washer solvent supply lines so that the washer solvent is cooled to thereby prevent a solvent from being vaporized before washing.

8. The vaporizer of any one of claims 1 through 3, **characterized in that** said washer solvent supply line is configured to be arranged at a position just below said gas ejecting end portion.

9. The vaporizer of claim 8, **characterized in that** the end portion of said washer solvent supply line is configured as a washer nozzle.

10. The vaporizer of claim 9, **characterized in that** the wash liquid stream containing a solvent is ejected from said end of said washer nozzle, to achieve more effective removal of adhered and hardened matters comprising a thin-film material adhered to an outer periphery of said gas ejecting end portion of said vaporization part.

11. A vaporizer having a vaporization part configured to vaporize a carrier gas which is supplied through an internally formed gas passage and which contains a material solution, **characterized in**
**that** said vaporizer is configured to include:
a first supply part configured to supply the carrier gas to said vaporization part;
a second supply part configured to supply the material solution into the carrier gas; and
a third supply part configured to supply a gas acting on the carrier gas emitted from a gas outlet of said vaporization part, near said gas outlet.

12. The vaporizer of claim 11, **characterized in that** said action is an aiding action for preventing occurrence of swirl flows near said gas outlet of said vaporization part for the carrier gas.

13. The vaporizer of claim 11 or 12, **characterized in that** said swirl flow occurrence prevention means comprises gas jets in a downward direction near said gas outlet.

14. The vaporizer of claim 13, **characterized in that** the gas jets for said swirl flow occurrence prevention means are ultra high-speed gas streams.

15. The vaporizer of any one of claims 11 through 14, **characterized in that** said vaporizer is one for MOCVD (metalorganic chemical vapor deposition).

16. The vaporizer of any one of claims 11 through 15, **characterized in that** said vaporizer further comprises a cooling system part configured to restrict vaporization of the material solution.

17. The vaporizer of claim 1 or 11, **characterized in that** said vaporizer further comprises a complete vaporization oriented high performance vaporization tube configured to define a high performance operation area to thereby completely vaporize the carrier gas which is to be ejected from said vaporization part and which contains the material solution.

18. A material solution vaporizing method of vaporizing, by a vaporizer, a carrier gas which is supplied through an internally formed gas passage and which contains a material solution, **characterized in**
**that** the method comprises:
a vaporization part gas supply step for supplying a gas to the vaporization part;
a carrier gas supply step for supplying: a material for preventing generation of bubbles of the carrier gas containing the material solution; and the material solution; into the carrier gas;
a cooling step for restricting vaporization of a solvent by cooling; and
a swirl flow prevention gas supply step for supplying a gas for preventing occurrence of swirl flows near a gas outlet of the vaporization part.

19. The material solution vaporizing method of claim 18, **characterized in that** the gas supply in said swirl flow prevention gas supply step comprises ultra high-speed gas streams in the downward direction near the gas outlet of the vaporization part, for the purpose of forming the carrier gas, which is ejected from the vaporizer and which contains the material solution, into a finely atomized state.

20. The material solution vaporizing method of claim 19, **characterized in that** the method further comprise the step of: decreasing an amount of an O gas to be supplied from the below, and achieving a vacuuming treatment by adding an O gas to an N₂ gas, for the purpose of enhancing implementability of formation of the finely atomized state.

21. A vaporizer washing method for a vaporizer configured to introduce a film-forming solution supplied via gas passage, into a vaporization part from an inlet, to thereby vaporize the material solution in the vaporization part, **characterized in**
**that** the method comprises the step of: ejecting a wash liquid toward the inlet.

22. The vaporizer washing method for a vaporizer of claim 21, **characterized in that** the film-forming material, the wash liquid, is dissolved in a solvent.

23. The vaporizer washing method for a vaporizer of claim 22, **characterized in that** the wash liquid is a solvent in which the film-forming material is soluble.

24. The vaporizer washing method for a vaporizer of any one of claims 21 through 23, **characterized in that** the washing is achieved by bringing the vaporization part into a reduced pressure state.

25. The vaporizer washing method for a vaporizer of any one of claims 21 through 24, **characterized in that** the wash liquid is ejected at a rate of 30cc/min or more.

26. The vaporizer washing method for a vaporizer of any one of claims 21 through 25, **characterized in that** the inlet and the jet port of the wash liquid are set at 25 mm or less in distance therebetween.

27. The vaporizer of any one of claims 1 through 17, **characterized in that** said vaporization part is provided with a drain port, said drain port is provided with a gas ejector, and an exclusion/disposal device is connected to a downstream of said gas ejector.
